# EUROPÄISCHE PATENTSCHRIFT

(11) **EP 3 444 851 B1**
(45) Veröffentlichungstag und Bekanntmachung des Hinweises auf die Patenterteilung: **26.07.2023**
(21) Anmeldenummer: 18000663.7
(22) Anmeldetag: 09.08.2018
(51) Int. Cl.: H01L 31/167, H01L 27/144

(54) **EMPFÄNGERBAUSTEIN**
RECEIVER MODULE
MODULE RÉCEPTEUR

(30) Priorität: 16.08.2017 DE 102017007683
(43) Veröffentlichungstag der Anmeldung: 20.02.2019
(73) Patentinhaber: AZUR SPACE Solar Power GmbH, 74072 Heilbronn (DE)
(72) Erfinder: Fuhrmann, Daniel, 74081 Heilbronn (DE); Lauermann, Thomas, 74076 Heilbronn (DE); Keller, Gregor, 74080 Heilbronn (DE)
(74) Vertreter: Koch Müller Patentanwaltsgesellschaft mbH

(56) Entgegenhaltungen:
- EP-A2- 0 392 373
- DE-A1-102016 001 387
- JP-A- S6 399 616
- JP-A- H05 315 927
- JP-A- S58 161 366
- JP-A- 2008 117 962
- JP-A- 2012 256 682
- JP-A- 2013 191 705
- US-A- 4 996 577
- US-A1- 2013 193 495
- US-A1- 2013 299 841

## Beschreibung

Die Erfindung betrifft einen Empfängerbaustein.

Empfängerbausteine sind bei Optokopplern hinlänglich bekannt. Einfache Optokoppler weisen einen Sendebaustein und einen Empfängerbaustein auf, wobei die beiden Bausteine galvanisch getrennt, jedoch optisch gekoppelt sind. Eine derartige Ausführungsform ist aus der US 4 996 577 bekannt.

Aus der DE 10 2016 001 387 A1 ist als Empfängerbaustein eine optisch betriebene Spannungsquelle und eine selbstsperrenden MOS-Transistorstruktur bekannt. Weiterer Empfängerbausteine mit selbstsperrenden Transistoren sind aus der JP S58 / 151 366 A und der US 2013 / 0 299 841 A1 bekannt. Weitere Halbleiterbauelemente sind aus JP H05 315 927 A, der US 2013 / 193 495 A1, JP S63 996 16 A, der JP 2013 / 191 705 A und der JP 2008 117 962 A bekannt.

Vor diesem Hintergrund besteht die Aufgabe der Erfindung darin, eine Vorrichtung anzugeben, die den Stand der Technik weiterbildet.

Die Aufgabe wird durch einen Empfängerbaustein mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Empfängerbaustein bereitgestellt.

Der Empfängerbaustein umfasst eine optisch betriebene Spannungsquelle, wobei die Spannungsquelle einen ersten Stapel mit einer Oberseite und einer Unterseite umfasst und auf Basis von stapelförmig angeordneten III-V-Halbleiterschichten auf einer Oberseite eines nicht Si-Substrats ausgebildet ist.

An der Oberseite des ersten Stapels ist ein erster elektrischer Anschlusskontakt und an einer Unterseite des nicht Si-Substrates ein zweiter elektrischer Anschlusskontakt ausgebildet.

Zwischen den beiden Anschlusskontakten liegt eine mittels Einstrahlung von Licht auf die Oberseite des ersten Stapels generierte Spannung an.

Der Empfängerbaustein umfasst einen zweiten Stapel mit einer III-V Halbleiterschichten umfassenden FET-Transistorstruktur.

Die FET-Transistorstruktur umfasst einen Steueranschluss, d.h. einen Gateanschluss, und einen Drainanschluss und einen Sourceanschluss.

Die FET-Transistorstruktur ist als ein selbstleitender Feldeffekttransistor ausgebildet.

Der Steueranschluss ist mit einem der beiden Anschlusskontakte und der Drainanschluss mit dem anderen der beiden Anschlusskontakte verschaltet.

Hierbei schließt der selbstleitende Feldeffekttransistor die beiden Anschlusskontakte der Spannungsquelle kurz, sofern die generierte Spannung unter einen Schwellwert sinkt.

Es sei angemerkt, dass der Schwellwert vorzugsweise gleich der Schwellspannung des Feldeffekttransistors entspricht. Oberhalb der Schwellspannung ist der Transistor geschlossen, d.h. der Kanal des Transistors wird von der an dem Gate anliegenden Spannung verarmt und verliert die Leitfähigkeit und vice versa.

Des Weiteren sei angemerkt, dass die Spannungsquelle für eine Erzeugung der Spannung wenigstens eine pn-Diode oder eine pin-Diode aus einem III-V Material umfasst. Hierbei ist der Bandabstand der Diode kleiner ausgebildet als die Energie des auf die Oberseite des ersten Stapels eingestrahlten Lichtes.

Es versteht sich, dass beispielweise für einen selbstleitenden N-Kanal Feldeffekttransistor eine negative Gatespannung angelegt werden muss, z. b. -2V, um den FET-Transistor zu sperren.

Es sei angemerkt, dass das nicht Si-Substrat vorzugsweise ein III-V Material, wie beispielsweise GaAs oder InP, umfasst oder aus einem III-V Material besteht oder insbesondere Ge-umfasst oder aus Ge besteht.

Ein Vorteil ist es, dass mit dem zu dem Ausgang der Spannungsquelle parallel geschalteter FET-Transistor im Dunkelfall der Spannungsabfall an der Spannungsquelle wesentlich beschleunigt wird, indem die Steuerspannung kurz nach dem Abschalten unter die Schwellspannung fällt. Hierdurch wird der FET-Transistor leitend und schließt die beiden Anschlusskontakte kurz. Die Ladung an der Spannungsquelle wird schnell abgebaut.

Ein weiterer Vorteil ist es, dass sich der Transistor sehr klein, d.h. mit einer geringen Gatebreite ausbilden lässt. Vorzugsweise liegt die Gatebreite unterhalb 0,3 mm, höchst vorzugsweise unterhalb 0,1 mm. Der Begriff der Gatebreite ist vorliegend gleichbedeutend mit dem Ausdruck Gateweite. Es zeigte sich, dass durch die Ausbildung von kleinen FET-Transistoren sich ein Anstieg der Spannung nach dem Einschalten des Lichtes nur wenig verlängert. Vorzugsweise weist der Transistor eine Gatelänge kleiner als die Gatebreite auf. Insbesondere liegt die Gatelänge in einem Bereich zwischen 50 µm und 0,2 µm.

In einer Weiterbildung ist der Drainanschluss mit dem ersten Anschlusskontakt und der Steueranschluss mit dem zweiten Anschlusskontakt verschaltet. Erfindungsgemäß ist zwischen dem Steueranschluss und dem Sourceanschluss eine Schottkydiode eingeschleift. Vorzugsweise umfasst die Schottkydiode III-V-Halbleiterschichten und ist monolithisch mit der Spannungsquelle integriert und insbesondere auf der Oberseite des zweiten Stapels ausgebildet.

In einer anderen Weiterbildung ist der Feldeffekttransistor als selbstleitender N-Kanal FET-Transistor oder als selbstleitender P-Kanal FET-Transistor ausgebildet.

Vorzugsweise ist der erste Anschlusskontakt mit einem positiven Potential und der zweite Anschlusskontakt mit einem negativen Potential beaufschlagt.

In einer Ausführungsform ist der erste Anschlusskontakt mit einem ersten Ausgangsanschluss und der Sourceanschluss mit einem zweiten Ausgangsanschluss verschaltet. Zwischen den beiden Ausgangsanschlüssen liegt die Ausgangsspannung an. Sofern der erste Stapel mit Gleichlicht bestrahlt wird, liegt als Ausgangsspannung eine Gleichspannung an. Wird der erste Stapel mit Wechsellicht bestrahlt liegt als Ausgangsspannung eine Wechselspannung an.

In einer Ausführungsform ist in einem Teilgebiet auf der Oberseite des ersten Stapels die FET-Struktur als ein zweiter Stapel mit einer Oberseite und einer Unterseite ausgebildet. Vorzugsweise sind die III-V Halbleiterschichten der beiden Stapel monolithisch integriert.

In einer anderen Ausführungsform weist der erste Stapel eine viereckige Form auf, wobei die Seitenflächen des ersten Stapels an der Oberseite des nicht Si-Substrates zurückversetzt sind, so dass sich ein erster umlaufender stufenförmiger Absatz ausbildet. Vorzugsweise ist die Stufenfläche um den ersten Stapel herum gleich groß ausgebildet.

In einer Weiterbildung ist der zweite Stapel an der Oberseite des ersten Stapels von dem Rand zurückversetzt, so dass sich ein zweiter umlaufender stufenförmiger Absatz ausgebildet, wobei der zweite Stapel eine wesentlich kleiner Grundfläche als der erste Stapel aufweist und auf der Oberfläche des ersten Stapels unsymmetrisch angeordnet ist. Vorzugsweise umfasst der erste Stapel eine Seitenlänge in einem Bereich zwischen 0,5 mm bis 4 mm. Vorzugsweise umfasst der zweite Stapel eine Seitenlänge zwischen 0,05 und 0,3 mm.

In einer Ausführungsform ist auf der FET-Transistorstruktur eine opake Schicht angeordnet, um die FET-Transistorstruktur gegen die Einstrahlung von Licht zu schützen. Vorzugsweise ist an der Unterseite des zweiten Stapels eine erste III-V-Isolationsschicht ausgebildet, um die FET-Transistorstruktur von der Spannungsquelle elektrisch zu isolieren. In einer Weiterbildung ist zusätzlich eine zweite III-V-Isolationsschicht ausgebildet.

In einer Weiterbildung weist die FET-Transistorstruktur eine oberhalb der Isolationsschicht angeordnete als Kanalschicht ausgebildete erste Transistorschicht und eine oberhalb der Kanalschicht ausgebildete zweite Transistorschicht auf.

Vorzugsweise umfasst die Spannungsquelle mehrere pn-Dioden, wobei zwischen zwei aufeinanderfolgenden pn-Dioden jeweils eine Tunneldiode ausgebildet ist und vorzugsweise weisen die pn-Dioden jeweils den gleichen Bandabstand und / oder die gleiche Materialzusammensetzung auf. Es versteht sich, dass bei einer Serienschaltung der mehreren pn-Dioden die Ausgangsspannung der Spannurigsquelle erhöht wird.

Es versteht sich weiterhin, dass insbesondere bei einer Serienschaltung von einer Vielzahl von Dioden sich insbesondere das Abklingen der Spannung wesentlich verlangsamt, sofern nicht mittels des Feldeffekttransistors die Ladungen abgeführt werden.

In einer Weiterbildung ist zwischen dem Steueranschluss und dem Sourceanschluss keine Diode, insbesondere keine Schottkydiode, eingeschleift. Hierbei sind die beiden Anschlusskontakte jeweils unmittelbar mit dem jeweilig zugeordneten Ausgangsanschluss verschaltet.

Hierdurch wird das Potential an dem Steueranschluss nicht gegenüber dem Sourceanschluss vorgespannt. Trotzdem ist der Feldeffekttransistor gesperrt, sofern an der Spannungsquelle die Betriebsspannung anliegt, indem zwischen dem Drainanschluss und dem Steueranschluss mittels der anliegenden Betriebsspannung ein Teil des Kanals geschlossen bleibt.

Ein Vorteil ist, dass sich ein Spannungsabfall an der Schottkydiode bzw. an der Diode vermeiden lässt und sich das Abklingverhalten verbessert und sich der Empfängerbaustein kostengünstiger herstellen lässt.

In einer Weiterbildung ist der zweite Anschlusskontakt mit einem zweiten Ausgangsanschluss verschaltet.

Erfindungsgemäß sind der Steueranschluss und der Sourceanschluss miteinander kurzgeschlossen.

Erfindungsgemäß ist zwischen dem Steueranschluss und dem Sourceanschluss eine Schottkydiode eingeschleift.

In einer anderen Weiterbildung ist der erste Stapel auf dem zweiten Stapel angeordnet und der erste Stapel eine wesentlich kleinere Grundfläche als der erste Stapel aufweist.

In einer Ausführungsform ist der erste Stapel lateral neben dem zweiten Stapel angeordnet und zwischen den beiden Stapeln ist ein gefüllter Graben ausgebildet.

Es versteht sich, dass die Diode vorzugsweise als eine Transistorstruktur ausgebildet ist.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: einen Empfängerbaustein in einer ersten Ausführungsform,
- Figur 2: ein Ersatzschaltbild mit einem N-Kanal FET Transistor eines Empfängerbausteins ergänzt um eine Schottkydiode,
- Figur 3: Spannungsverlauf des Empfängerbausteins,
- Figur 4: ein Ersatzschaltbild mit einem P-Kanal FET Transistor eines Empfängerbausteins ergänzt um eine Schottkydiode,
- Figur 5: ein Ersatzschaltbild eines Empfängerbausteins mit dem NKanal FET Transistor ohne Schottkydiode,
- Figur 6: ein Ersatzschaltbild eines Empfängerbausteins mit dem P-Kanal FET Transistor ohne Schottkydiode,
- Figur 7: einen Empfängerbausteins in einer zweiten Ausführungsform,
- Figur 8: einen Empfängerbausteins in einer nicht beanspruchten dritten Ausführungs-form.

Es versteht sich, dass in allen Ausführungsformen anstelle einer Schottkydiode auch eine normale Diode sich ausbilden lässt.

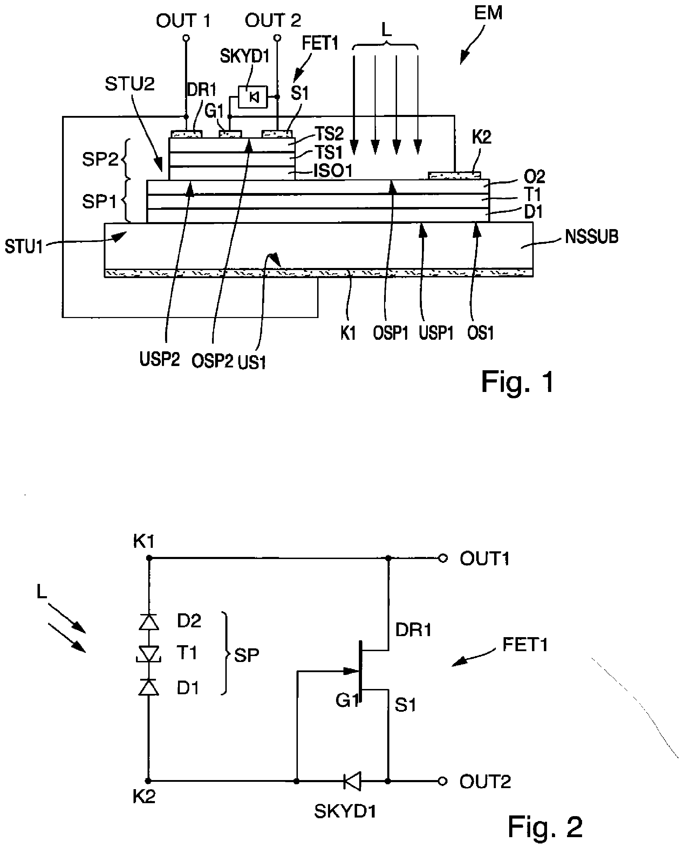

Die Abbildung der Figur 1 zeigt einen Empfängerbaustein EM in einer ersten Ausführungsform. Ein derartiger Empfängerbaustein EM ist vorzugsweise als Teil eines nicht dargestellten Optokopplers zusammen mit einem Sendeteil in einem gemeinsamen Gehäuse integriert.

Der Empfängerbaustein EM umfasst in einem ersten Stapel SP1 eine optisch betriebene Spannungsquelle SP auf Basis von stapelförmig angeordneten III-V-Halbleiterschichten ausgebildet. Der erste Stapel SP1 umfasst eine Oberseite OSP1 und eine Unterseite USP1 und ist mit der Unterseite USP1 auf einer Oberseite OS1 eines nicht Si-Substrats NSSUB angeordnet.

Die Spannungsquelle SP weist an einer Unterseite US1 des nicht Si-Substrates NSSUB einen ersten elektrischen Anschlusskontakt K1 auf. An einer Oberseite OSP1 des Stapels der III-V Halbleiterschichten ist ein zweiter elektrischer Anschlusskontakt K2 ausgebildet. Eine Einstrahlung von Licht L findet nur an der Oberseite OSP1 des Stapels statt.

Die Spannungsquelle SP umfasst eine auf dem nicht Si-Substrat aufliegende erste Diode D1 und eine zweite Diode D2. Zwischen der ersten Diode D1 und der zweiten Diode D2 ist eine Tunneldiode T1 ausgebildet. Mittels der Tunneldiode T1 sind die zwei Dioden D1 und D2 in Serie geschaltet. Anders ausgedrückt die Teilspannungen der beiden Dioden D1 und D2 addieren sich.

Bei einer Lichteinstrahlung L auf die Oberseite des ersten Stapels SP1 liegt zwischen den beiden Anschlusskontakten K1 und K2 eine mittels des Lichtes L generierte Spannung an.

Insbesondere um Kurzschlüsse an den seitlichen Flächen zu vermeiden, sind die Schichten der Spannungsquelle SP, d.h. der erste Stapel SP1 gegenüber dem nicht Si-Substrat NSSUB an allen Seiten zurückversetzt, sodass sich ein erster umlaufende stufenförmiger Absatz STU1 ausbildet.

Auf der Oberseite OSP1 des ersten Stapels SP1 ist ein zweiter Stapel SP2 mit einer III-V Halbleiterschichten umfassenden FET-Transistorstruktur FET1 ausgebildet. Der zweite Stapel SP2 weist eine Oberseite OSP2 und eine Unterseite USP2 auf.

Die FET-Transistorstruktur FET1, die vorliegend als eine selbstleitender n-Kanal Feldfeffekttransistor ausgebildet ist, umfasst einen Steueranschluss G1 und einem Drainanschluss DR1 und einem Sourceanschluss 51.

Der zweite Stapel SP2 weist eine wesentlich kleinere Grundfläche als der erste Stapel SP1 auf und ist auf der Oberfläche OSP1 des ersten Stapels SP1 unsymmetrisch angeordnet, d.h. unterschiedlich weit zu dem Rand der Oberseite OSP1 beabstandet.

Der zweite Stapel SP2 ist also gegenüber dem Rand des ersten Stapels SP1 an allen Seiten zurückversetzt, sodass sich ein zweiter umlaufender stufenförmiger Absatz STU2 ausbildet.

An der Unterseite des zweiten Stapels SP2 ist eine III-V- Isolationsschicht ISO1 ausgebildet, um die FET-Transistorstruktur FET1 von der Spannungsquelle SP elektrisch zu isolieren.

Oberhalb der Isolationsschicht ISO1 ist eine als Kanalschicht ausgebildete erste Transistorschicht TS1 angeordnet. Oberhalb der Kanalschicht ist eine zweite Transistorschicht TS2 ausgebildet.

Der Drainanschluss DR1 ist mit dem ersten Anschlusskontakt K1 und mit dem ersten Ausgangsanschluss OUT1 verschaltet. Der Steueranschluss G1 und der Sourceanschluss S1 sind mit dem zweiten Anschlusskontakt K2 und mit einem zweiten Ausgangsanschluss OUT2 verschaltet.

Zwischen dem Steueranschluss G1 und dem Sourceanschluss S1 ist eine Schottky-Diode SKYD1 eingeschleift.

Der Feldeffekttransistor schließt die beiden Anschlusskontakte K1 und K2 bzw. die beiden Ausgangsanschlüsse OUT1 und OUT2 kurz, sofern die generierte Spannung unter einen Schwellwert d. h. unter die Schwellspannung des Feldeffekttransistors sinkt.

In der Abbildung der Figur 2 ein Ersatzschaltbild eines Empfängerbaustein EM gemäß der ersten Ausführungsform dargestellt. Nachfolgend werden nur die Unterschiede zu der Ausführungsform dargestellt in der Figur 1 erläutert.

Die Schottkydiode SKYD1 ist zwischen dem Steueranschluss G1 und dem Sourceanschluss S1 eingeschleift um das Potential an dem Steueranschluss G1 gegenüber dem Sourceanschluss 51 vorzuspannen, d. h. liegt an der Spannungsquelle SP die Betriebsspannung an, wird der Feldeffekttransistor gesperrt.

Durch das Einschleifen der Schottkydiode SKYD1 verringert sich das Potential an dem zweiten Ausgangsanschluss OUT2 gegenüber dem Potential an dem zweiten Anschlusskontakt K2 um einen geringen Spannungsabfall, da die Schottkydiode SKYD1 im Betriebsfall in Vorwärtsrichtung gepolt ist.

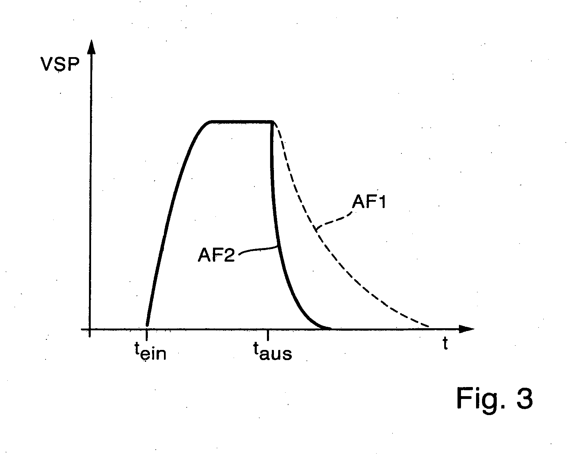

In der Abbildung der Figur 3 wird ein Spannungsverlauf des Empfängerbausteins EM gemäß der ersten Ausführungsform dargestellt. Nachfolgend werden nur die Unterschiede zu der Ausführungsform dargestellt in der Figur 1 erläutert.

Aufgetragen ist der zeitliche Verlauf der Spannung der Spannungsquelle SP.

Zu einem Zeitpunkt tₑᵢₙ wird die Oberseite OSP1 des ersten Stapels SP1 mit Licht L bestrahlt und zu einem Zeitpunkt tₐᵤₛ wird das Licht L ausgeschaltet.

Es zeigt sich, dass an dem Zeitpunkt tₑᵢₙ die Spannung schnell bis zu einem Maximalwert ansteigt und nach dem Ausschalten ohne Feldeffekttransistor eine Abklingkurve AF1 und mit Feldeffekttransistor eine Abklingkurve AF2 aufweist. Anders ausgedrückt, mittels des Feldeffekttransistors wird das Abklingverhalten der Spannungsquelle wesentlich verbessert.

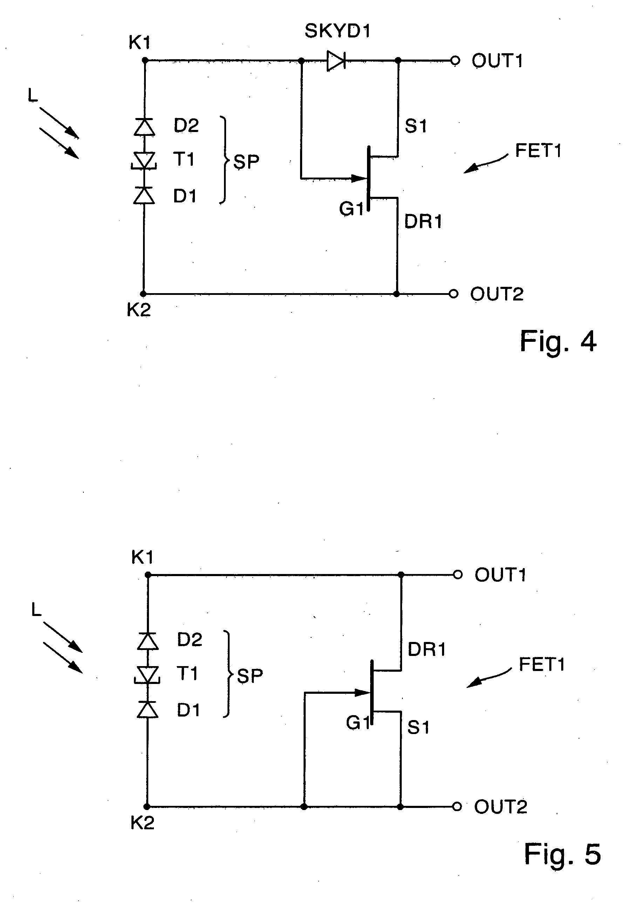

In der Abbildung der Figur 4 ist ein Ersatzschaltbild eines Empfängerbaustein mit einem P-Kanal FET Transistor ergänzt um eine Schottkydiode dargestellt. Nachfolgend werden nur die Unterschiede zu der Ausführungsform, dargestellt in der Figur 1, erläutert.

Die FET-Transistorstruktur FET1 ist vorliegend als ein selbstleitender p-Kanal Feldfeffekttransistor ausgebildet.

Der Steueranschluss G1 ist mit dem ersten Anschlusskontakt K1 und der Sourceanschluss S1 ist dem ersten Ausgangsanschluss OUT1 verschaltet.

Zwischen dem Steueranschluss G1 und dem Sourceanschluss S1 ist die Schottky-Diode SKYD1 eingeschleift, um das Potential an dem Steueranschluss G1 gegenüber dem Sourceanschluss S1 vorzuspannen, d. h. liegt an der Spannungsquelle SP die Betriebsspannung an, wird der Feldeffekttransistor gesperrt.

Durch das Einschleifen der Schottkydiode SKYD1 verringert sich das Potential an dem ersten Ausgangsanschluss OUT1 gegenüber dem Potential an dem zweiten Anschlusskontakt K1 um einen geringen Spannungsabfall, da die Schottkydiode SKYD1 im Betriebsfall in Vorwärtsrichtung gepolt ist.

Der Drainanschluss DR1 ist mit dem zweiten Anschlusskontakt K2 und mit dem zweiten Ausgangsanschluss OUT2 verschaltet.

Der Feldeffekttransistor schließt die beiden Anschlusskontakte K1 und K2 bzw. die beiden Ausgangsanschlüsse OUT1 und OUT2 kurz, sofern die generierte Spannung unter einen Schwellwert d. h. unter die Schwellspannung des Feldeffekttransistors sinkt.

In der Abbildung der Figur 5 ist ein Ersatzschaltbild eines Empfängerbausteins EM mit dem N-Kanal FET Transistor ohne Schottkydiode dargestellt. Nachfolgend werden nur die Unterschiede zu der Ausführungsform dargestellt in der Figur 2 erläutert.

Die Schottkydiode SKYD1 ist zwischen dem Steueranschluss G1 und dem Sourceanschluss S1 des N-Kanal FET Transistors FET1 weggelassen, d.h. das Potential an dem Steueranschluss G1 wird nicht gegenüber dem Sourceanschluss S1 vorgespannt. Trotzdem ist der Feldeffekttransistor gesperrt, sofern an der Spannungsquelle SP die Betriebsspannung anliegt, indem zwischen dem Drainanschluss DR1 und dem Steueranschluss G1 mittels der anliegenden Betriebsspannung ein Teil des Kanals geschlossen bleibt.

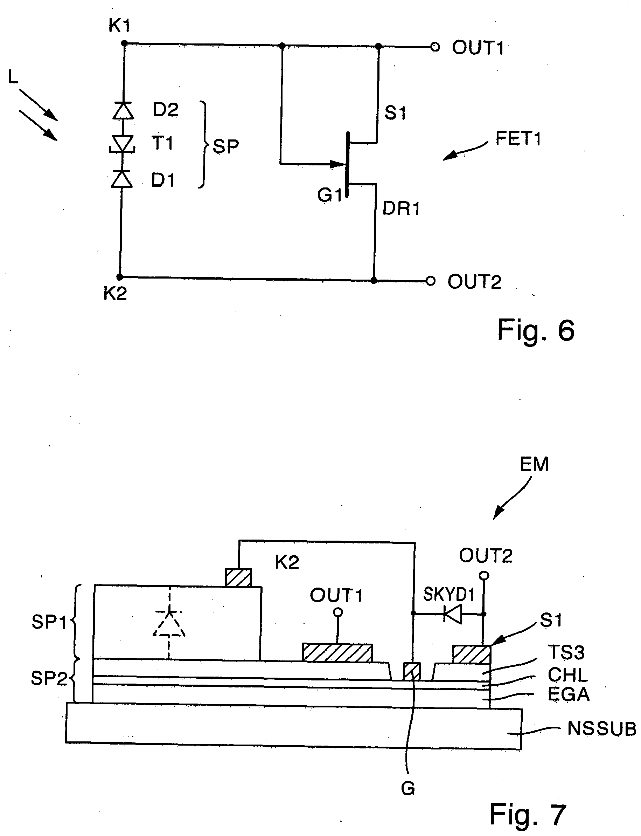

In der Abbildung der Figur 6 ist ein Ersatzschaltbild eines Empfängerbausteins EM mit dem P-Kanal FET Transistor ohne Schottkydiode dargestellt in der Figur 4 abgebildet. Nachfolgend werden nur die Unterschiede zu der Ausführungsform dargestellt in der Figur 4 erläutert.

Die Schottkydiode SKYD1 ist zwischen dem Steueranschluss G1 und dem Sourceanschluss S1 des P-Kanal FET Transistors FET1 weggelassen, d.h. das Potential an dem Steueranschluss G1 wird nicht gegenüber dem Sourceanschluss S1 vorgespannt. Trotzdem ist der Feldeffekttransistor gesperrt, sofern an der Spannungsquelle SP die Betriebsspannung anliegt, indem zwischen dem Drainanschluss DR1 und dem Steueranschluss G1 mittels der anliegenden Betriebsspannung ein Teil des Kanals geschlossen bleibt.

Die Abbildung der Figur 7 zeigt einen Empfängerbaustein EM in einer zweiten Ausführungsform. Nachfolgend werden nur die Unterschiede zu der Ausführungsform, dargestellt in der Figur 1, erläutert.

Der erste Stapel SP1 des Empfängerbausteins EM ist auf dem zweiten Stapel SP2 angeordnet. Der zweite Stapel ist auf dem nicht Si-Substrats NSSUB angeordnet.

Der zweite Stapel SP2 ist lateral größer ausgebildet als der erste Stapels SP1 und umfasst eine auf dem nicht Si-Substrat ausgebildete vorzugsweise semiisolierende III-V Halbleiterschicht EGA. Insbesondere umfasst oder besteht die III-V Halbleiterschicht EGA aus GaAs.

Oberhalb der III-V Halbleiterschicht EGA ist eine ganzflächige Kanalschicht CHL ausgebildet. Auf der Kanalschicht CHL ist eine lateral strukturierte elektrisch leitfähige III-V Transistorschicht TS3 ausgebildet. Auf der Transistorschicht TS3 sind der Drainanschluss DR1 und der Sourceanschluss S1 ausgebildet. Zwischen dem Drainanschluss DR1 und dem Sourceanschluss S1 ist auf der Kanalschicht CHL der Steueranschluss G1 ausgebildet. In einer nicht dargestellten Ausführungsform ist dem Bereich zwischen dem Drainanschluss DR1 und dem Sourceanschluss S1 und unterhalb des Steueranschlusses G1 eine Isolationsschicht, vorzugsweise umfassend ein Dielektrikum wie beispielsweise Hf-Oxid und / oder Si-Oxid und / oder Si-Nitrid ausgebildet.

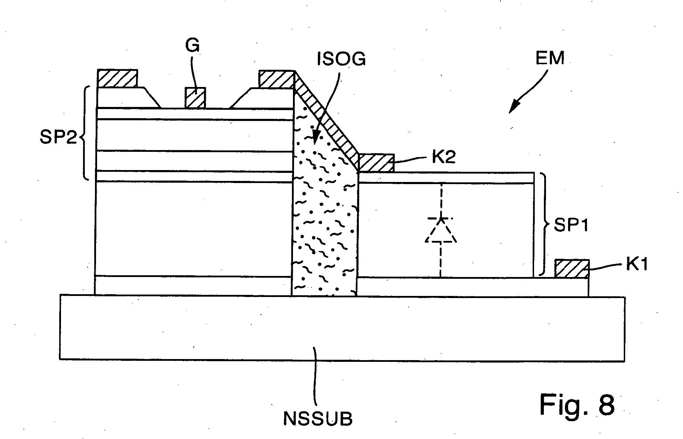

Die Abbildung der Figur 8 zeigt einen Empfängerbaustein EM in einer nicht beanspruchten dritten Ausführungsform. Nachfolgend werden nur die Unterschiede zu der Ausführungsform, dargestellt in der Figur 1 bzw. der Figur 7, erläutert.

Der erste Stapel SP1 des Empfängerbausteins EM ist lateral neben dem zweiten Stapel SP2 angeordnet, wobei die Schichtenfolge unterhalb des zweiten Stapel SP1 der Schichtenfolge des ersten Stapel SP1 entspricht. Beide Stapel SP1 und SP2 sind jeweils auf einem gemeinsamen nicht Si-Substrats NSSUB angeordnet.

Zwischen den beiden Stapeln SP1 und SP2 ist ein Graben ISOG ausgebildet, wobei der Graben ISOG mit einem elektrisch isolierenden Material gefüllt ist. Vorzugsweise umfasst das Material ein Dielektrikum, wie beispielsweise Hf-Oxid und / oder Si-Oxid und / oder Si-Nitrid. Der zweite Anschlusskontakte K2 ist mittels einer Leiterbahn entweder mit dem Sourceanschluss S1 oder mit dem Drainanschluss DR1 verschaltet. Der erste Anschlusskontakt K1 ist lateral neben dem ersten Stapel SP1 unmittelbar auf der Oberfläche des nicht Si-Substrates angeordnet.

## Patentansprüche

1. Empfängerbaustein (EM) aufweisend
- eine optisch betriebene Spannungsquelle (SP), wobei die Spannungsquelle (SP) einen ersten Stapel (SP1) mit einer Oberseite (OSP1) und einer Unterseite (USP1) umfasst und auf Basis von stapelförmig angeordneten III-V-Halbleiterschichten auf einer Oberseite (OS1) eines nicht Si-Substrats (NSSUB) ausgebildet ist, und an der Oberseite (OSP1) des ersten Stapels (SP1) einen zweiten elektrischen Anschlusskontakt (K2) und an einer Unterseite (US1) des nicht Si-Substrates (NSSUB) einen ersten elektrischen Anschlusskontakt (K1) aufweist, wobei zwischen den beiden Anschlusskontakten (K1, K2) eine mittels Einstrahlung von Licht (L) auf die Oberseite (OSP1) des ersten Stapels (SP1) generierte Spannung anliegt,
- einen zweiten Stapel (ST2) mit einer III-V Halbleiterschichten umfassende FET-Transistorstruktur (FET1) mit einen Steueranschluss (G1) und einem Drainanschluss (DR1) und einem Sourceanschluss (S1),
- der erste Stapel und der zweite Stapel ein gemeinsames nicht Si-Substrat (NSSUB) aufweisen,
- die FET-Transistorstruktur (FET1) als ein selbstleitender Feldeffekttransistor ausgebildet ist und der Steueranschluss (G1) und der Sourceanschluss mit einer der beiden Anschlusskontakte (K1, K2) verschaltet sind und der Drainanschluss (DR1) mit dem anderen der beiden Anschlusskontakte (K1, K2) verschaltet ist, wobei der Feldeffekttransistor die beiden Anschlusskontakte (K1, K2) kurz schließt, sofern die generierte Spannung unter einen Schwellwert sinkt, und
der Steueranschluss (G1) und der Sourceanschluss (S1) miteinander kurzgeschlossen sind, oder
zwischen dem Steueranschluss (G1) und dem Sourceanschluss (S1) eine Schottkydiode (SKYD1) eingeschleift ist.

2. Empfängerbaustein (EM) nach Anspruch 1, **dadurch gekennzeichnet, dass** der Drainanschluss (DR1) mit dem ersten Anschlusskontakt (K1) und der Steueranschluss (G1) mit dem zweiten Anschlusskontakt (K2) verschaltet ist.

3. Empfängerbaustein (EM) nach Anspruch 1 oder Anspruch 2, **dadurch gekennzeichnet, dass** der Feldeffekttransistor als ein selbstleitender N-Kanal FET-Transistor oder als ein selbstleitender P-Kanal FET-Transistor ausgebildet ist.

4. Empfängerbaustein (EM) nach einem der Ansprüche 1 bis 3, **dadurch gekennzeichnet, dass** der erste Anschlusskontakt (K1) mit einem ersten Ausgangsanschluss (OUT1) und der Sourceanschluss (S1) mit einem zweiten Ausgangsanschluss (OUT2) verschaltet ist.

5. Empfängerbaustein (EM) nach einem der Ansprüche 1 bis 4, **dadurch gekennzeichnet, dass** in einem Teilgebiet auf der Oberseite (OSP1) des ersten Stapels (SP1) die FET-Struktur als ein zweiter Stapel (SP2) mit einer Oberseite (OSP2) und einer Unterseite (USP2) ausgebildet ist und die III-V Halbleiterschichten der beiden Stapel (SP1, SP2) monolithisch integriert sind.

6. Empfängerbaustein (EM) nach einem der Ansprüche 1 bis 5, **dadurch gekennzeichnet, dass** der erste Stapel (SP1) eine viereckige Form aufweist und die Seitenflächen des ersten Stapels (SP1) an der Oberseite (OSP1) des nicht Si-Substrates (NSSUB) zurückversetzt sind, so dass sich ein erster umlaufender stufenförmiger Absatz (STU1) ausbildet.

7. Empfängerbaustein (EM) nach einem der Ansprüche 1 bis 6, **dadurch gekennzeichnet, dass** der zweite Stapel (SP2) an der Oberseite (OSP1) des ersten Stapels (SP1) von dem Rand zurückversetzt ist, so dass sich eine zweiter umlaufender stufenförmiger Absatz (STU2) ausgebildet, wobei der zweite Stapel (SP2) eine wesentlich kleiner Grundfläche als der erste Stapel (SP1) aufweist und auf der Oberfläche (OSP1) des ersten Stapels (SP1) unsymmetrisch angeordnet ist.

8. Empfängerbaustein (EM) nach einem der Ansprüche 1 bis 7, **dadurch gekennzeichnet, dass** auf der FET-Transistorstruktur (FET1) eine opake Schicht angeordnet ist, um die FET-Transistorstruktur (FET1) gegen die Einstrahlung von Licht (L) zu schützen und an der Unterseite (USP2) des zweiten Stapels (SP2) eine erste III-V- Isolationsschicht (ISO1) ausgebildet ist, um die FET-Transistorstruktur (FET1) von der Spannungsquelle (SP) elektrisch zu isolieren.

9. Empfängerbaustein (EM) nach einem der Ansprüche 1 bis 8, **dadurch gekennzeichnet, dass** die FET-Transistorstruktur (FET1) eine oberhalb der Isolationsschicht (ISO1) angeordnete als Kanalschicht ausgebildete erste Transistorschicht (TS1) und eine oberhalb der Kanalschicht (KS) ausgebildete zweite Transistorschicht (TS2) aufweist.

10. Empfängerbaustein (EM) nach einem der Ansprüche 1 bis 9, **dadurch gekennzeichnet, dass** die Spannungsquelle (SP) mehrere pn-Dioden (D1, D2) umfasst, wobei zwischen zwei aufeinanderfolgenden pn-Dioden (D1, D2) jeweils eine Tunneldiode (T1) ausgebildet ist und die pn-Dioden (D1, D2) jeweils den gleichen Bandabstand aufweisen.

11. Empfängerbaustein (EM) ach einem der Ansprüche 1 bis 10, **dadurch gekennzeichnet, dass** der zweite Anschlusskontakt (K2) mit dem zweiten Ausgangsanschluss (OUT2) verschaltet ist.

12. Empfängerbaustein (EM) nach Ansprüche 1 bis 11 **dadurch gekennzeichnet, dass** erste Stapel (SP1) auf dem zweiten Stapel (SP2) angeordnet und der erste Stapel (SP1) von dem Rand zurückversetzt ist.

13. Empfängerbaustein (EM) nach Ansprüche 1 bis 12 **dadurch gekennzeichnet, dass** der erste Stapel (SP1) lateral neben dem zweiten Stapel (SP2) angeordnet und zwischen den beiden Stapeln (SP1, SP2) ein gefüllter Graben (ISOG) ausgebildet ist.

## Claims

1. Receiver module (EM) comprising
- an optically operated voltage source (SP), wherein the voltage source (SP) comprises a first stack (SP1) with an upper side (OSP1) and a lower side (USP1) and is constructed on the basis of III-V semiconductor layers, which are arranged in stack shape, on an upper side (OS1) of a non-Si-substrate (NSSUB), and has a second electrical terminal contact (K2) at the upper side (OSP1) of the first stack (SP1) and a first electrical terminal contact (K1) at a lower side (US1) of the non-Si-substrate (NSSUB), wherein a voltage generated by means of irradiation of light (L) on the upper side (OSP1) of the first stack (SP1) lies between the two terminal contacts (K1, K2),
- a second stack (ST2) with an FET transistor structure (FET1), which comprises III-V semiconductor layers, with a control terminal (G1) and a drain terminal (DR1) and a source terminal (S1),
- the first stack and the second stack have a common non-Si-substrate (NSSUB),
- the FET transistor structure (FET1) is constructed as a self-conducting field effect transistor and the control terminal (G1) and the source terminal are connected with one of the two terminal contacts (K1, K2) and the drain terminal (DR1) is connected with the other one of the two terminal contacts (K1, K2), wherein the field effect transistor short-circuits the two terminal contacts (K1, K2) insofar as the generated voltage drops below a threshold value, and
the control terminal (G1) and the source terminal (S1) are short-circuited together or
a Schottky diode (SKYD1) is connected between the control terminal (G1) and the source terminal (S1).

2. Receiver module (EM) according to claim 1, **characterised in that** the drain terminal (DR1) is connected with the first terminal contact (K1) and the control terminal (G1) is connected with the second terminal contact (K2).

3. Receiver module (EM) according to claim 1 or claim 1, **characterised in that** the field effect transistor is constructed as a self-conducting N-channel FET transistor or as a self-conducting P-channel FET transistor.

4. Receiver module (EM) according to any one of claims 1 to 3, **characterised in that** the first terminal contact (K1) is connected with a first output terminal (OUT1) and the source terminal (S1) is connected with a second output terminal (OUT2).

5. Receiver module (EM) according to any one of claims 1 to 4, **characterised in that** the FET structure is constructed as a second stack (SP2) with an upper side (OSP2) and a lower side (USP2) in a sub-region on the upper side (OSP1) of the first stack (SP1) and the III-V semiconductor layers of the two stacks (SP1, SP2) are monolithically integrated.

6. Receiver module (EM) according to any one of claims 1 to 5, **characterised in that** the first stack (SP1) has a rectangular form and the side surfaces of the first stack (SP1) are set back at the upper side (OSP1) of the non-Si-substrate (NSSUB) so that a first encircling step-shaped shoulder (STU1) is formed.

7. Receiver module (EM) according to any one of claims 1 to 6, **characterised in that** the second stack (SP2) is set back at the upper side (OSP1) of the first stack (SP1) from the edge so that a second encircling step-shaped shoulder (STU2) is formed, wherein the second stack (SP2) has a substantially smaller plan area than the first stack (SP1) and is asymmetrically arranged on the surface (OSP1) of the first stack (SP1).

8. Receiver module (EM) according to any one of claims 1 to 7, **characterised in that** an opaque layer is arranged on the FET transistor structure (FET1) so as to protect the FET transistor structure (FET1) from irradiation by light (L) and a first III-V insulation layer (ISO1) is formed at the lower side (USP2) of the second stack (SP2) so as to electrically insulate the FET transistor structure (FET1) from the voltage source (SP).

9. Receiver module (EM) according to any one of claims 1 to 8, **characterised in that** the FET transistor structure (FET1) comprises a first transistor layer (TS1) arranged above the insulation layer (ISO1) and formed as a channel layer and a second transistor layer (TS2) constructed above the channel layer (KS).

10. Receiver module (EM) according to any one of claims 1 to 9, **characterised in that** the voltage source (SP) comprises a plurality of pn diodes (D1, D2), wherein a respective tunnel diode (T1) is formed between each two successive pn diodes (D1, D2) and the pn diodes (D1, D2) each have the same band spacing.

11. Receiver module (EM) according to any one of claims 1 to 10, **characterised in that** the second terminal contact (K2) is connected with the second output terminal (OUT2).

12. Receiver module (EM) according to any one of claims 1 to 11, **characterised in that** the first stack (SP1) is arranged on the second stack (SP2) and the first stack (SP1) is set back from the edge.

13. Receiver module (EM) according to any one of claims 1 to 12, **characterised in that** the first stack (SP1) is arranged laterally adjacent to the second stack (SP2) and a filled trench (ISOG) is formed between the two stacks (SP1, SP2).

## Revendications

1. Module de réception (EM) comportant
- une source de tension (SP) optique, dans lequel la source de tension (SP) comprend une première pile (SP1) avec une face supérieure (OSP1) et une face inférieure (USP1) et est configurée à base de couches semi-conductrices III-V agencées en forme de pile sur une face supérieure (OS1) d'un substrat non Si (NSSUB), et présente sur la face supérieure (OSP1) de la première pile (SP1) un deuxième contact de raccordement électrique (K2) et sur une face inférieure (US1) du substrat non Si (NSSUB) un premier contact de raccordement électrique (K1), une tension générée par le rayonnement de lumière (L) sur la face supérieure (OSP1) de la première pile (SP1) étant appliquée entre les deux contacts de raccordement (K1, K2),
- une deuxième pile (ST2) avec une structure de transistor FET (FET1) comprenant des couches semi-conductrices III-V avec une borne de commande (G1) et une borne de drain (DR1) et une borne de source (S1),
- la première pile et la deuxième pile présentent un substrat non Si (NSSUB) commun,
- la structure de transistor FET (FET1) est configurée comme un transistor à effet de champ autoconducteur et la borne de commande (G1) et la borne de source sont connectées avec un des deux contacts de raccordement (K1, K2) et la borne de drain (DR1) est connectée avec l'autre des deux contacts de raccordement (K1, K2), le transistor à effet de champ court-circuitant les deux contacts de raccordement (K1, K2) lorsque la tension générée tombe au-dessous d'une valeur seuil, et
la borne de commande (G1) et la borne de source (S1) sont court-circuitées entre elles ou
une diode Schottky (SKYD1) est insérée entre la borne de commande (G1) et la borne de source (S1).

2. Module de réception (EM) selon la revendication 1, **caractérisé en ce que** la borne de drain (DR1) est connectée avec le premier contact de raccordement (K1) et la borne de commande (G1) avec le deuxième contact de raccordement (K2).

3. Module de réception (EM) selon la revendication 1 ou la revendication 2, **caractérisé en ce que** le transistor à effet de champ est configuré comme un transistor FET à canal N autoconducteur ou comme un transistor FET à canal P autoconducteur.

4. Module de réception (EM) selon une des revendications 1 à 3, **caractérisé en ce que** le premier contact de raccordement (K1) est connecté avec une première borne de sortie (OUT1) et la borne de source (S1) avec une deuxième borne de sortie (OUT2).

5. Module de réception (EM) selon une des revendications 1 à 4, **caractérisé en ce que** dans une zone partielle sur la face supérieure (OSP1) de la première pile (SP1), la structure du FET est configurée comme une deuxième pile (SP2) avec une face supérieure (OSP2) et une face inférieure (USP2) et les couches semi-conductrices III-V des deux piles (SP1, SP2) sont intégrées de façon monolithique.

6. Module de réception (EM) selon une des revendications 1 à 5, **caractérisé en ce que** la première pile (SP1) présente une forme rectangulaire et les faces latérales de la première pile (SP1) sont reculées au niveau de la face supérieure (OSP1) du substrat non Si, de sorte qu'un premier épaulement périphérique en forme de gradin (STU1) se forme.

7. Module de réception (EM) selon une des revendications 1 à 6, **caractérisé en ce que** la deuxième pile (SP2) est reculée par rapport au bord au niveau de la face supérieure (OSP1) de la première pile (SP1), de sorte qu'un deuxième épaulement périphérique en forme de gradin (STU2) se forme, la deuxième pile (SP2) présentant une superficie sensiblement plus petite que la première pile (SP1) et étant agencée de manière asymétrique sur la face supérieure (OSP1) de la première pile (SP1).

8. Module de réception (EM) selon une des revendications 1 à 7, **caractérisé en ce qu'**une couche opaque est disposée sur la structure de transistor FET (FET1) pour protéger la structure de transistor FET (FET1) contre le rayonnement de lumière (L) et qu'une première couche d'isolation III-V (ISO1) est formée sur la face inférieure (USP2) de la deuxième pile (SP2) pour isoler électriquement la structure de transistor FET (FET1) de la source de tension (SP).

9. Module de réception (EM) selon une des revendications 1 à 8, **caractérisé en ce que** la structure de transistor FET (FET1) comporte une première couche de transistor (TS1) disposée comme couche de canal au-dessus de la couche d'isolation (ISO1) et une deuxième couche de transistor (TS2) formée au-dessus de la couche de canal (KS).

10. Module de réception (EM) selon une des revendications 1 à 9, **caractérisé en ce que** la source de tension (SP) comporte plusieurs diodes pn (D1, D2), une diode de tunnel (T1) étant configurée à chaque fois entre deux diodes pn (D1, D2) successives et les diodes pn (D1, D2) présentant chacune la même largeur de bande interdite.

11. Module de réception (EM) selon une des revendications 1 à 10, **caractérisé en ce que** le deuxième contact de raccordement (K2) est connecté avec la deuxième borne de sortie (OUT2).

12. Module de réception (EM) selon une des revendications 1 à 11, **caractérisé en ce que** la première pile (SP1) est disposée sur la deuxième pile (SP2) et la première pile (SP1) est reculée par rapport au bord.

13. Module de réception (EM) selon une des revendications 1 à 12, **caractérisé en ce que** la première pile (SP1) est disposée latéralement à côté de la deuxième pile (SP2) et qu'une tranchée remplie (ISOG) est formée entre les deux piles (SP1, SP2).
